(19) Europäisches Patentamt
European Patent Office
Office européen des brevets

(11) Veröffentlichungsnummer: **0 146 723**
**B1**

(12) **EUROPÄISCHE PATENTSCHRIFT**

(45) Veröffentlichungstag der Patentschrift: **14.10.87**

(51) Int. Cl.⁴: **C 23 C 18/22**

(21) Anmeldenummer: **84112973.7**

(22) Anmeldetag: **27.10.84**

(54) **Verfahren zur Haftaktivierung von Polyamidsubstraten für die stromlose Metallisierung.**

(30) Priorität: **04.11.83 DE 3339856**

(43) Veröffentlichungstag der Anmeldung: **03.07.85 Patentblatt 85/27**

(45) Bekanntmachung des Hinweises auf die Patenterteilung: **14.10.87 Patentblatt 87/42**

(84) Benannte Vertragsstaaten: **BE CH DE FR GB IT LI NL SE**

(56) Entgegenhaltungen: **EP-A-0 081 129**

(73) Patentinhaber: **BAYER AG, Konzernverwaltung RP Patentabteilung, D-5090 Leverkusen 1 Bayerwerk (DE)**

(72) Erfinder: **Sirinyan, Kirkor, Dr., Humperdinckstrasse 12, D-5060 Bergisch Gladbach 2 (DE)**
Erfinder: **Wolf, Gerhard Dieter, Dr., Wilhelm-Busch- Strasse 29, D-4047 Dormagen 5 (DE)**
Erfinder: **Merten, Rudolf, Dr., Berta- von- Suttner-Strasse 55, D-5090 Leverkusen (DE)**
Erfinder: **von Gizycki, Ulrich, Dr., Wiembach Allee 24, D-5090 Leverkusen 3 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 146 723 B1

LIBER, STOCKHOLM 1987

## Beschreibung

Es ist allgemein bekannt, daß die für zahlreiche Kunststoffgegenstände übliche Vorbehandlung durch Ätzen mit stark oxidierenden Säuren für Polyamidsubstrate ungeeignet ist.

Es ist deshalb bereits vorgeschlagen worden (vgl. DE-A 2 946 343), das Polyamidsubstrat zunächst mit einer wäßrigen alkalischen Lösung mit einem pH-Wert von mindestens etwa 10 bei erhöhter Temperatur vorzubehandeln, bevor mit einer organischen Säure geätzt wird. Für den letzten Schritt wurden vorzugsweise Trichlor- und Trifluoressigsäure eingesetzt, deren Handhabung wegen ihrer Flüchtigkeit und hohen Toxizität aufwendige Arbeitsschutzmaßnahmen erfordert. Darüber hinaus führt diese immer noch sehr drastische Vorbehandlungsmethode zu einer nicht reversiblen Verschlechterung der wichtigsten mechanischen Eigenschaften der Polyamidformkörper.

Gemäß DE-A 3 137 587 wird der Versuch unternommen, diese Nachteile dadurch zu beheben, daß man die Polyamidsubstrate mit einem Gemisch aus wasserhaltiger Säure und einem wasserlöslichen, auf Polyamide quellend wirkenden organischen Lösungsmittel vorbehandelt. Es zeigte sich jedoch, daß auch dieses Ätzverfahren die Polyamidformkörper derart schädigt, daß diese für zahlreiche Zwecke nicht einsetzbar sind.

In der DE-A 2 022 109 wird ein Verfahren zur Vorbehandlung von zu metallisierenden Kunststoff-Formkörpern beschrieben, welches dadurch gekennzeichnet ist, daß man den Kunststoff in Anwesenheit eines ihn (an)lösenden oder anquellenden Lösungsmittels mit einem gelösten Metallsalzkomplex behandelt. Als Kunststoff wird auch Polyamid erwähnt. Bei den Komplexsalzen handelt es sich im wesentlichen um Komplexe des Dimethylsulfoxids mit LiCl, $SnCl_2$, $ZnCl_2$, $FeCl_2$, $FeCl_3$, $Hg_2Cl_2$, $MnCl_2$, $AgNO_3$, u.a. Als Aktivatorlösung wird beispielshaft nur eine ammoniakalische Silbernitratlösung beschrieben. Bei der Nacharbeitung dieser Methode wurden jedoch nur Metallauflagen mit ungenügender Haftfestigkeit erzielt. Auch führen die $AgNO_3$-aktivierten Substrate oft zum Zusammenbrechen der Metallisierungsbäder.

In der EP-A-81 129 wird ein Verfahren zur Vorbehandlung von im metallisierenden Polyamid-Formkörpern in $CaCl_2$-haltigen methanolischen Aktivatorlösungen beschrieben.

Es wurde nun überraschenderweise gefunden, daß man diese Nachteile weitgehend vermeiden und zu gut haftenden Metallbeschichtungen auf Polyamidsubstraten gelangen kann, ohne deren mechanische Eigenschaften, wie Kerbschlagzähigkeit, Schlagzähigkeit und Festigkeit negativ zu beeinflussen, wenn man die Substrate mit

a) der Lösung einer Mischung von LiCl, $CaCl_2$ und/oder $MgCl_2$ mit $AlCl_3$, $FeCl_3$ und/oder $TiCl_4$ in einem niederen aliphatischen oder araliphatischen Alkohol und

b) einer Aktivatorlösung auf der Basis

1) anorganischer Komplexverbindungen der Formel

$$M^{n+}[E^{m+}\ Hal_z^{-}]$$

worin M für Wasserstoff-, Alkaliatome oder Erdalkaliatom(e),

Hal für Halogen, vorzugsweise Cl, und

E für ein Edelmetallatom Ib oder VIIIa des Periodensystems, vorzugsweise Pt und Pd, mit der Wertigkeit m und der Koordinationszahl z steht, wobei z-m = n ist, oder

2) der in 1) genannten Edelmetalle in kolloidaler Form oder

3) nichtkomplexer Salze der in 1) genannten Edelmetalle der Formel

$$E^{m+}\ Hal^{-}_p\ (p=m)$$

nacheinander oder gleichzeitig, d.h. also mit einem Gemisch von a) und b), behandelt.

Bevorzugte Salzmischungen sind $CaCl_2/AlCl_3$. Bevorzugt anzuwendende Edelmetallkomplexe sind solche der Formel $Na_2(PdCl_4)$, $Na_4(PtCl_6)$ und $Ca(PdCl_4)$.

Geeignete Edelmetalle in kolloidaler Form leiten sich vor allem von den Metallen Pd, Pt, Au und Ag ab und sind beispielsweise in "Kunststoffgalvanisierung" von R. Weiner, Eugen G. Lenze Verlag, Saulgau/Württ. (1973), Seiten 180-209 beschrieben.

Geeignete alkoholische Lösungsmittel sind: Methanol, Ethanol, Isopropanol, n-Propanol, n-Butanol, Benzylalkohol und Phenylethylalkohol. Besonders bevorzugt ist Methanol. Selbstverständlich sind auch Mischungen dieser Lösungsmittel einsetzbar.

Gewünschtenfalls können auch übliche Polyamidweichmacher (0,2 - 10 Gew.-%, vorzugsweise 0,5-5 Gew.-%) bezogen auf die gesamte Flüssigkeitsmenge) zugesetzt werden. Beispielhaft seien Benzolsulfonsäuremonoethylamid, p-Toluolsulfonsäureamid, Dioxidiphenylsulfon und Dibenzylphenol genannt.

Die Konzentration an katalytisch aktivem Metall in den Behandlungsbädern soll 0,01-10 g, vorzugsweise 0,1-1 g pro Liter betragen.

Die Gesamtmenge der erfindungsgemäß zu verwendenden Salzgemische beträgt vorzugsweise 2,5-25 Gew.-% (besonders bevorzugt 5-15 Gew.-%) bezogen auf die Flüssigkeitsmenge. Der Anteil der genannten Al-, Fe- und Ti-Salze sollte 30 % nicht übersteigen (bezogen auf die Gesamtsalzmenge, die bis zur jeweiligen Löslichkeitsgrenze ansteigen kann). Vorzugsweise beträgt der Anteil dieser Salze 0,1 - 6 %, insbesondere 0,5 - 3 %.

Die Behandlung der Substrate erfolgt im allgemeinen bei -15° C bis zum Siedepunkt der verwendeten Lösungsmittel, vorzugsweise bei 15-30° C.

Eine bevorzugte Verfahrensvariante besteht darin, daß man das Substrat mit einem Gemisch

der metallkomplexhaltigen Aktivatorlösung und dem salzhaltigen, alkoholischen Quell- bzw. Lösungsmittelsystem behandelt.

Bei der praktischen Durchführung dieser Variante geht man zweckmäßigerweise so vor, daß man den Polyamidformkörper bei Raumtemperatur in dieses Quellmittel-/Aktivatorsystem eintaucht, nach 0,5-10 Minuten, vorzugsweise 1-5 Minuten, aus dem Bad entfernt, von anhaftendem Lösungsmittel befreit, anschließend in ein Sensibilisierungsbad überführt und schließlich der stromlosen Metallisierung unterwirft.

Die Entfernung der Lösungsmittel erfolgt im allgemeinen durch Verdampfen, gegebenenfalls unter reduziertem Druck. Höher siedende Lösungsmittel werden zweckmäßigerweise durch Extraktion oder Spülen mit niedrigsiedenden Lösungsmitteln entfernt.

Die Sensibilisierung kann grundsätzlich in den üblichen sauren Bädern auf der Basis von $SnCl_2$- und $ZnCl_2$-Lösungen erfolgen. Vorzugsweise wird sie jedoch in alkalischen Bädern mit Formalin, Dimethylboran, Natriumborhydrid, Hydrazin oder Natriumhydrogenhypophosphit durchgeführt. Ganz besonders bevorzugt ist die Sensibilisierung in ammoniakalkalischen wäßrigen Alkohollösungen (Methanol, Ethanol), welche die vorstehend genannten Reduktionsmittel enthalten, bei Raumtemperatur während 1-5 Minuten.

Die sensibilisierten Oberflächen können direkt oder nach einem Spülgang (zur Beseitigung von Reduktionsmittelresten) in herkömmliche Metallisierungsbäder eingebracht werden.

Eine ganz besonders bevorzugte Ausführungsform des erfindungsgemäßen Verfahrens besteht aus folgenden Arbeitsgängen: Eintauchen des Substrates in das Edelmetallkomplex/Quellmittelsystem, Verdampfen des Lösungsmittels und Eintauchen der so aktivierten Oberflächen in das Metalisierungsbad (Reduktion und Metallisierung).

Diese Variante ist ganz besonders für aminboranhaltige Nickelbäder oder formalinhaltige Kupferbäder geeignet.

Die auf diese Weise auf den Polyamidwerkstoffen erzeugten Metallauflagen können gewünschtenfalls noch galvanisch verstärkt werden. Für diese elektrische Metallabscheidung eignen sich vor allem Cu, Ni, Cr, Ag, Au und Pt. Dabei empfiehlt es sich zunächst eine galvanische Vorverstärkung bis zu Schichtdicken von ca. 20 µm in schwach sauren oder basischen Galvanisierungsbädern, beispielsweise in Ni-Bädern bei pH 5-6, vorzunehmen.

Das erfindungsgemäße Verfahren ist auf sämtliche handelsüblichen Polyamidtypen - wie Polyamid-6, Polyamid-6,6, Polyamid-10, -11 und -12 sowie Mischtypen - anwendbar. Es können sowohl füllstoffhaltige als auch ungefüllte Polyamide mit gleichem Erfolg behandelt werden. Füllstoffbeimischungen verkürzen je nach Anteil die erforderliche Ätzzeit gegenüber dem ungefüllten Polyamid.

Darüber hinaus sind extrem schlagfeste Substrate, wie mit Kautschuk-, Polyisopren- oder Polybutadien-Latices gepfropfte oder gemische Polyamide bestens geeignet.

**Beispiel 1**

Eine 90 x 150 x 3 mm starke glasfaserverstärkte (30 Gew.-%) Kunststoffplatte aus Polyamid-6 wird in einem Haftbekeimungsbad, welches

| | | |
|---|---|---|
| 1400 | ml | Methanol (technisch, wäßrig) |
| 125 | g | $CaCl_2$ |
| 2,0 | g | $AlCl_3$ |
| 400 | ml | $H_2O$ dest. |
| 3 | g | $Na_2Pd\ Cl_4$ (etwa 15 % Pd) |

enthält, 5 Minuten bei Raumtemperatur (RT) haftaktiviert und getrocknet. Anschließend wird die Platte in einem Bad, bestehend aus

| | | |
|---|---|---|
| 1200 | ml | Ethanol |
| 24 | ml | $NH_3$-Lösung (25 %ig) |
| 50 | ml | 2n-DMAB (Dimethylaminboran) |

5 Min. bei RT sensibilisiert, mit destilliertem Wasser gespült und dann in einem herkömmlichen hypophosphithaltigen Vernickelungsbad der Fa. Blasberg AG, Solingen bei 30° C 25 Minuten vernickelt. Die Haftfestigkeit der Metallauflage, bestimmt durch die Abzugskraft nach DIN 53 494, beträgt $\geqslant$ 60 N/25 mm. Die galvanische Verstärkung von der o.a. Polyamid-Platte für die Bestimmung der Abzugskraft wurde wie folgt durchgeführt:

a) eine halbe Minute Dekapieren in 10 %iger $H_2SO_4$

b) Spülen

c) 5 Minuten im Halbglanznickelbad, Spannung 9 Volt, Badtemperatur 60° C

d) Spülen

e) eine halbe Minute Dekapieren

f) 90 Minuten im Kupferbad; Spannung 1,9 Volt, Badtemperatur 28° C

g) Spülen.

**Beispiel 2**

Eine 90 x 150 x 3 mm starke Kunststoffplatte aus einem handelsüblichen kautschukgepfropften Polyamid-6 wird in einem Haftaktivierungsbad aus

| | | |
|---|---|---|
| 120 | g | $MgCl_2$ |
| 2,0 | g | $FeCl_3$ |
| 125 | ml | $H_2O_{dest}$ |
| 1400 | ml | Methanol |
| 0,9 | g | $PdCl_2$ (etwa 60 % Pd) |

bei 40° C 7,5 Minuten behandelt. Anschließend wird die Platte in einer Lösung aus

| | | |
|---|---|---|
| 900 | ml | Methanol |
| 22 | ml | Hydrazinhydrat (30 %ige Lösung) |
| 15 | ml | Ammoniak |

bei RT sensibilisiert, mit destilliertem Wasser gespült und dann gemäß Beispiel 1 galvanisch verstärkt. Die Metallauflage haftet an der Plattenoberfläche sehr gut. Ihre Haftfestigkeit bestimmt nach DIN 53 494 beträgt 50 N/25 mm.

**Beispiel 3**

Ein Formteil aus kautschuk-modifiziertem Polyamid-6 wird in einer Lösung aus

| | | |
|---|---|---|
| 1500 | ml | Methanol (technisch, wäßrig) |
| 125 | g | $CaCl_2$ |
| 4,0 | g | $TiCl_4$ |

7 Minuten bei RT behandelt und dann in einer handelsüblichen salzsauren kolloidalen Pdhaltigen Aktivierungsbad 4 Min. aktiviert, gespült, in einem handelsüblichen $SnCl_2$-haltigen Sensibilisierungsbad sensibilisiert, gemäß Beispiel 1 vernickelt bzw. die Metallauflage galvanisch verstärkt.

Man bekommt einen Polymer-Metall-Verbundwerkstoff mit einer sehr guten Metallhaftung.

**Beispiel 4**

Eine 90 x 150 x 3 mm starke Kunststoffplatte aus einem handelsüblichen Polyamid-6,6 wird in einem Haftaktivierungsbad aus

| | | |
|---|---|---|
| 1500 | ml | EtOH |
| 120 | g | $CaCl_2$ |
| 20 | ml | p-Toluolsulfonamid |
| 3 | g | $FeCl_3$ |
| 1,5 | g | $PdCl_2$ (etwa 60 % Pd) |

bei RT behandelt, getrocknet, gemäß Beispiel 1 sensibilisiert und dann in einem handelsüblichen Verkupferungsbad 25 Minuten verkupfert bzw. die Kupferauflage gemäß Beispiel 1 auf dem galvanischen Wege verstärkt. Man bekommt einen Metall-Polymer-Verbundwerkstoff mit einer sehr guten Haftfestigkeit.

**Beispiel 5**

Ein Formteil aus einem mit 30 Gew.-% glasfaserverstärkten Polyamid-6 wird nach Beispiel 1 behandelt, aktiviert, sensibilisiert, auf dem chemischen Wege vernickelt und dann galvanisch verstärkt. Die galvanische Verstärkung wird wie folgt durchgeführt:

a) eine halbe Minute Dekapieren in 10 %iger $H_2SO_4$

b) Spülen

c) 5 Minuten im Halbglanznickelbad; Spannung 4 Volt, Badtemperatur 60° C, abgeschiedene Halbglanznickelschicht: ca. 4 bis 5 µm.

d) Spülen

e) eine halbe Minute Dekapieren

f) 30 Minuten im Kupferbad, Spannung 1,9 Volt, Badtemperatur 28° C, aufgebrachte Kupferschicht 15 bis 16 µm

g) Spülen

h) eine halbe Minute Dekapieren

i) 8 Minuten Glanznickelbad, Spannung 5,5 Volt, Badtemperatur 52° C, abgeschiedene Nickelschicht ca. 20 µm

j) Spülen

k) Tauchen in Oxalsäure (0,5 %ige wäßrige Lösung)

l) 3 Minuten Glanzchrombad, Spannung 4.5 Volt, Badtemperatur 40° C, abgeschiedene Chromschicht ca. 0,3 µm

m) Spülen

n) Entgiften in einer 40 %igen Bisulfitlösung

o) Spülen in destilliertem Wasser.

Der so metallisierte Formkörper wurde der Temperatur-Wechselprüfung nach DIN 53 496 ausgesetzt, wobei die Wärmelagerung bei +110° C und die Kältelagerung bei -40° C erfolgte. Die Metallauflage haftet an der Formkörperoberfläche so fest, daß sie keine Veränderung zeigt.

**Beispiel 6**

Ein Formteil aus kautschuk-modifiziertem Polyamid-6 wird in einer Lösung aus

| | | |
|---|---|---|
| 1500 | ml | MeOH |
| 100 | g | $CaCl_2$ |
| 3 | g | $BCl_3$ |
| 1,5 | g | $PdCl_2$ |
| 3 | g | $AlCl_3$ |

bei 25° C 4 Minuten behandelt, mit destilliertem Wasser gewaschen, gemäß Beispiel 1 sensibilisiert, gemäß Beispiel 1 mit einer elektrisch leitenden Ni-Auflage versehen und dann die dünne Metallauflage auf dem galvanischen Wege gemäß Beispiel 5 verstärkt.

Der so haftfest metallisierte Formkörper wurde der Temperatur-Wechselprüfung gemäß Beispiel 5 ausgesetzt. Die Metallauflage haftet an der Formkörperoberfläche so fest, daß sie keine Veränderung zeigt.

**Beispiel 7**

Ein Formteil aus einem mit 40 Gew.-% mineralfaserverstärkten Polyamid-6 wird in einer Lösung aus

| | | |
|---|---|---|
| 1000 | ml | n-Butanol |
| 100 | g | LiCl |
| 25 | g | $AlCl_3$ |
| 0,9 | g | $H_2PtCl_6$ (etwa 40 % Pt) |

bei 30° C behandelt, gemäß Beispiel 1 sensibilisiert, gemäß Beispiel 1 vernickelt und dann gemäß Beispiel 5 die Ni-Auflage galvanisiert. Die Metallauflage haftet an der Formkörperoberfläche so fest, daß sie den Temperatur-Wechseltest nach DIN 53 496 besteht.

**Beispiel 8**

Eine 90 x 150 x 3 mm starke Kunststoffplatte aus mit 40 Gew.-% mineralfaserverstärkten Polyamid-6 wird in einer Lösung gemäß Beispiel 1 haftaktiviert, sensibilisiert, vernickelt und dann galvanisiert. Man bekommt einen Polymer-Metall-Verbundwerkstoff, deren Haftfestigkeit bestimmt durch die Abzugskraft nach DIN 53 494 50 N/25 mm beträgt.

**Beispiel 9**

7 Normstäbchen aus einem mit 30 % kautschukversetzten Polyamid-6 werden nach Beispiel 1 vorbehandelt, sensibilisiert und chemisch vernickelt. Aus den Schlagzähigkeitsuntersuchungen nach DIN 53 453/ISO R 179 geht hervor, daß ihre Schlagzähigkeit von dem Gesamtmetallisierungsvorgang nicht beeinflußt wird.

**Beispiel 10**

7 Normstäbchen aus einem handelsüblichen mit 40 % mineralfasernverstärkt und kautschukmodifizierten Polyamid-6, werden nach Beispiel 6 haftaktiviert und dann metallisiert. Man bekommt Prüfkörper mit einer haftfesten Metallauflage. Aus den Schlagzähigkeitsuntersuchungen nach DIN 53 453/ISO R 179 geht hervor, daß ihre Schlagzähigkeit von dem Haftaktivierungs- und Vernickelungsvorgang nicht beeinflußt wird.

**Beispiel 11**

Eine 90 x 150 x 3 mm starke glasfaserverstärkte (30 Gew.-%) Kunststoffplatte aus Polyamid-6 wird in einem Vorbehandlungsbad, welches

| | | |
|---|---|---|
| 1500 | ml | Methanol (technisch, wäßrig) |
| 125 | g | $CaCl_2$ |
| 5 | g | $AlCl_3$ |

enthält, 7 Minuten bei 27,5° C behandelt, mit destilliertem Wasser gewaschen, in einer Aktivierungslösung bestehend aus

| | | |
|---|---|---|
| 1000 | ml | Ethanol |
| 0,4 | g | $PdCl_2$ |

5 Minuten bei RT aktiviert, mit destilliertem Wasser gespült und dann nach Beispiel 1 sensibilisiert bzw. vernickelt. Man bekommt einen Metall-Polymer-Verbundwerkstoff mit einer sehr guten Haftfestigkeit.

**Patentansprüche**

1. Verfahren zur Haftaktivierung von Substratoberflächen von Formteilen aus Polyamiden für die stromlose Metallisierung, wobei man die Substrate mit

a) der Lösung einer Mischung von $CaCl_2$, LiCl und/oder $MgCl_2$ mit $AlCl_3$, $FeCl_3$ und/oder $TiCl_4$ in einem niederen aliphatischen oder araliphatschen Alkohol und

b) einer Aktivatorlösung auf der Basis

1) anorganischer Komplexverbindungen der Formel

$$M^{n+} [E^{m+} Hal^-_z]$$

worin M für Wasserstoff- oder Alkaliatome oder Erdalkaliatom(e),

Hal Halogen, vorzugsweise Cl, und

E für ein Edelmetallatom Ib oder VIIIa des Periodensystems mit der Wertigkeit m und der Koordinationszahl z stehen, wobei z-m = n ist,

2) der in 1) genannten Edelmetalle in kolloidaler Form oder

3) nichtkomplexer Salze der in 1) genannten Edelmetalle der Formel

$$E^{m+} Hal^-_p \ (p = m)$$

nacheinander oder gleichzeitig behandelt.

2. Verfahren nach Anspruch 1, dadurch gekennzeichnet, daß die so behandelten Substrate direkt in die Metallisierungsbäder eingebracht werden.

3. Verfahren nach Anspruch 1, dadurch gekennzeichnet, daß man ein Gemisch aus $CaCl_2$ und $AlCl_3$ einsetzt.

4. Verfahren nach Anspruch 1, dadurch gekennzeichnet, daß man einer Lösung von $CaCl_2$ und $AlCl_3$ in Methanol behandelt.

5. Verfahren nach Anspruch 1, dadurch gekennzeichnet, daß man die behandelten Substrate in einem ammoniakalkalischen aminoboranhaltigen oder formalinhaltigen Metallisierungsbad metallisiert.

6. Verfahren nach Anspruch 1, dadurch gekennzeichnet, daß man als Aktivatorlösungen solche auf der Basis von Komplexverbindungen einsetzt.

7. Verfahren nach Anspruch 1-6, dadurch gekennzeichnet, daß man als Edelmetalle Pd, Pt, Au oder Ag einsetzt.

## Claims

1. Process for the adhesion-activation, for electroless metallisation, of substrate surfaces of mouldings made of polyamides, wherein the substrates are treated, successively or simultaneously, with

a) the solution of a mixture of $CaCl_2$, LiCl and/or $MgCl_2$ with $AlCl_3$, $FeCl_3$ and/or $TiCl_4$ in a lower aliphatic or araliphatic alcohol and

b) an activator solution based on

1) inorganic complex compounds of the formula

$M^{n+}$ [$E^{m+}$ $Hal^{-}_{z}$]

wherein

M represents hydrogen or alkali metal atoms or alkaline earth metal atom(s),

Hal represents halogen, preferably Cl, and

E represents a noble metal atom Ib or VIIIa of the periodic system, having the valency m and the coordination number z, z-m being n,

2) the noble metals mentioned in 1), in colloidal form, or

3) non-complex salts of the noble metals mentioned in 1) of the formula

$E^{m+}$ $Hal^{-}_{p}$ (p = m).

2. Process according to Claim 1, characterised in that the substrates thus treated are introduced directly into the metallising baths.

3. Process according to Claim 1, characterised in that a mixture of $CaCl_2$ and $AlCl_3$ is used.

4. Process according to Claim 1, characterised in that the treatment is carried out with a solution of $CaCl_2$ and $AlCl_3$ in methanol.

5. Process according to Claim 1, characterised in that the treated substrates are metallised in an ammonia-alkaline metallising bath containing aminoborane or containing formalin.

6. Process according to Claim 1, characterized in that the activator solutions used are those based on complex compounds.

7. Process according to Claim 1-6, characterised in that Pd, Pt, Au or Ag are used as the noble metals.

## Revendications

1. Procédé pour activer l'adhérence à la surface de substrats consistant en pièces façonnées en polyamides pour la métallisation chimique, dans lequel on traite successivement ou simultanément les substrats avec

a) la solution d'un mélange de $CaCl_2$, LiCl et/ou $MgCl_2$ avec $AlCl_3$, $FeCl_3$ et/ou $TiCl_4$ dans un alcool aliphatique inférieur ou araliphatique et

b) une solution d'activateur à base

1) de composés inorganiques complexes de formule

$M^{n+}$ $E^{m+}$ $Hal^{-}_{z}$

dans laquelle M représente des atomes d'hydrogène ou de métaux alcalins ou un ou plusieurs atomes de métaux alcalino-terreux,

Hal est un halogène, de préférence Cl, et

E est un atome de métal noble du Groupe Ib ou VIIIa du Système Périodique de valence m et de nombre de coordination z, avec z-m = n,

2) des métaux nobles mentionnés en 1) sous une forme colloïdale ou bien

3) des sels non complexes des métaux nobles mentionnés en 1), de formule

$E^{m+}$ $Hal^{-}_{p}$ (p = m).

2. Procédé suivant la revendication 1, caractérisé en ce que les substrats ainsi traités sont plongés directement dans les bains de métallisation.

3. Procédé suivant la revendication 1, caractérisé en ce qu'on utilise un mélange de $CaCl_2$ et de $AlCl_3$.

4. Procédé suivant la revendication 1, caractérisé en ce qu'on traite une solution de $CaCl_2$ et de $AlCl_3$ dans du méthanol.

5. Procédé suivant la revendication 1, caractérisé en ce qu'on métallise les substrats traités dans un bain ammoniacal de métallisation contenant un aminoborane ou de la formaline.

6. Procédé suivant la revendication 1, caractérisé en ce qu'on utilise comme solutions d'activateurs des solutions à base de composés complexes.

7. Procédé suivant les revendications 1 à 6, caractérisé en ce qu'on utilise comme métaux nobles le palladium, le platine, l'or ou l'argent.